# EUROPÄISCHE PATENTSCHRIFT

(11) **EP 1 095 284 B1**
(45) Veröffentlichungstag und Bekanntmachung des Hinweises auf die Patenterteilung: **12.02.2003**
(21) Anmeldenummer: 99945864.9
(22) Anmeldetag: 01.07.1999
(51) Int. Cl.: G01R 29/00

(54) **SCHALTUNG ZUR ERMITTLUNG DER ZEITDIFFERENZ ZWISCHEN FLANKEN EINES ERSTEN UND EINES ZWEITEN DIGITALEN SIGNALS**
CIRCUIT FOR DETERMINING THE TIME DIFFERENCE BETWEEN TWO EDGES OF A FIRST AND OF A SECOND DIGITAL SIGNAL
CIRCUIT POUR LA DETERMINATION DE LA DIFFERENCE TEMPORELLE ENTRE LES FLANCS D'UN PREMIER ET D'UN SECOND SIGNAL NUMERIQUE

(30) Priorität: 08.07.1998 DE 19830570
(43) Veröffentlichungstag der Anmeldung: 02.05.2001
(73) Patentinhaber: Infineon Technologies AG, 81669 München (DE)
(72) Erfinder: BUCK, Martin, D-81243 München (DE)
(74) Vertreter: Fischer, Volker, Dipl.-Ing.
(86) Internationale Anmeldenummer: DE9902008
(87) Internationale Veröffentlichungsnummer: WO00003254

(56) Entgegenhaltungen:
- EP-A- 0 576 150
- EP-A- 0 639 004
- DE-C- 19 506 543
- US-A- 5 245 231

## Beschreibung

Schaltung zur Ermittlung der Zeitdifferenz zwischen Flanken eines ersten und eines zweiten digitalen Signals

Die Erfindung betrifft eine Schaltung zur Ermittlung der Zeitdifferenz zwischen Flanken eines ersten und eines zweiten digitalen Signals.

Eine derartige Schaltung ist in der DE-C1 195 06 543 beschrieben. Bei dieser wird einer Reihenschaltung von Invertern ein erstes Signal zugeführt. Die Ausgänge je zweier aufeinanderfolgender Inverter sind mit Eingängen von UND-Gattern verbunden. Die UND-Gatter werden durch ein zweites Signal aktiviert beziehungsweise deaktiviert. Bei einer positiven Flanke des zweiten Signals erfolgt eine Aktivierung der UND-Gatter, woraufhin diese durch Vergleich ihrer Eingangssignale an ihrem Ausgang anzeigen, ob eine positive Flanke des ersten Signals bereits die mit ihnen verbundene Inverter der Reihenschaltung durchlaufen hat oder nicht. Die Ausgangssignale der UND-Gatter werden in Flip-Flop-Schaltungen gespeichert.

Der Erfindung liegt die Aufgabe zugrunde, eine Schaltung der eingangs erwähnten Art anzugeben, für die eine geringere Anzahl von Schaltungskomponenten benötigt wird als beim genannten Stand der Technik.

Diese Aufgabe wird mit einer Schaltung gemäß Anspruch 1 gelöst. Vorteilhafte Aus- und Weiterbildungen der Erfindung sind Gegenstand abhängiger Ansprüche.

Die erfindungsgemäße Schaltung zur Ermittlung der Zeitdifferenz zwischen Flanken eines ersten und eines zweiten digitalen Signals weist einen ersten Eingang zum Zuführen des ersten Signals zu einer Reihenschaltung mehrerer Grundelemente auf. Jedes der Grundelemente hat eine Speichereinheit zum Speichern des am Eingang des Grundelementes anliegenden Signalpegels, wobei der Ausgang des Speicherelementes mit dem Eingang des nächsten Grundelementes verbunden ist. Weiterhin weist die Schaltung einen zweiten Eingang zum Zuführen des zweiten Signals auf, der mit einem Steuereingang jedes Grundelementes verbunden ist. Die Speicherelemente übernehmen bei einem ersten Pegel des zweiten Signals den im vorhergehenden Speicherelement gespeicherten Signalpegel und behalten bei einem zweiten Pegel des zweiten Signals den jeweils in ihnen gespeicherten Signalpegel bei. Weiterhin weist die Schaltung Vergleichseinheiten auf, denen jeweils die von den Speichereinheiten zweier benachbarten Grundelemente gespeicherten Signalpegel zugeführt werden, woraufhin die Vergleichseinheiten an ihren Ausgängen entsprechende Ergebnissignale liefern. Dabei liefern die Vergleichseinheiten bei Zuführung zweier gleicher Signalpegel jeweils ein anderes Ergebnissignal als bei Zuführung zweier unterschiedlicher Signalpegel.

Erfindungsgemäß ist es also vorgesehen, die Speichereinheiten innerhalb der Reihenschaltung aus Grundelementen, also im Signalpfad des ersten Signals anzuordnen. Die Reihenschaltung der Grundelemente dient der Ermittlung der Zeit zwischen dem Auftreten einer Flanke des ersten Signales am Eingang der Reihenschaltung und dem Auftreten einer Flanke des zweiten Signales und hat die Funktion einer Laufzeitkette. Somit tragen die in diese Reihenschaltung integrierten Speicherelemente, die jeweils eine Verzögerung des an ihrem Ausgang sich einstellenden Signalpegels gegenüber dem in ihnen zu speichernden Signalpegel bewirken, zur Laufzeitverzögerung der Flanke des ersten Signales bei.

Die Speicherelemente dienen also zweierlei Funktion: Zum einen dem Speichern der Information, wie weit die Flanke des ersten Signals bis zum Auftreten der Flanke des zweiten Signals durch die Reihenschaltung der Grundelemente gelaufen ist und zum zweiten der Verzögerung der Flanke des ersten Signals, die sich durch die Reihenschaltung der Grundelemente ausbreitet. Bei der eingangs erwähnten DE-C1 195 06 543 sind dagegen verschiedene Komponenten für die Verzögerung des ersten Signals in einer Reihenschaltung zuständig und zum Speichern des beim Auftreten der Flanke des zweiten Signals ermittelten Ergebnisses. In der genannten Druckschrift sind dies im ersten Fall Inverter und im zweiten Fall Flip-Flops. Daher kommt demgegenüber die erfindungsgemäße Schaltung aufgrund der Doppelfunktion ihrer Speicherelemente mit weniger Komponenten aus.

Die Erfindung wird im folgenden anhand der Figuren näher erläutert.
- Figur 1: zeigt ein Ausführungsbeispiel der Erfindung und
- Figur 2: zeigt die Signalverläufe des ersten und zweiten Signals aus Figur 1.

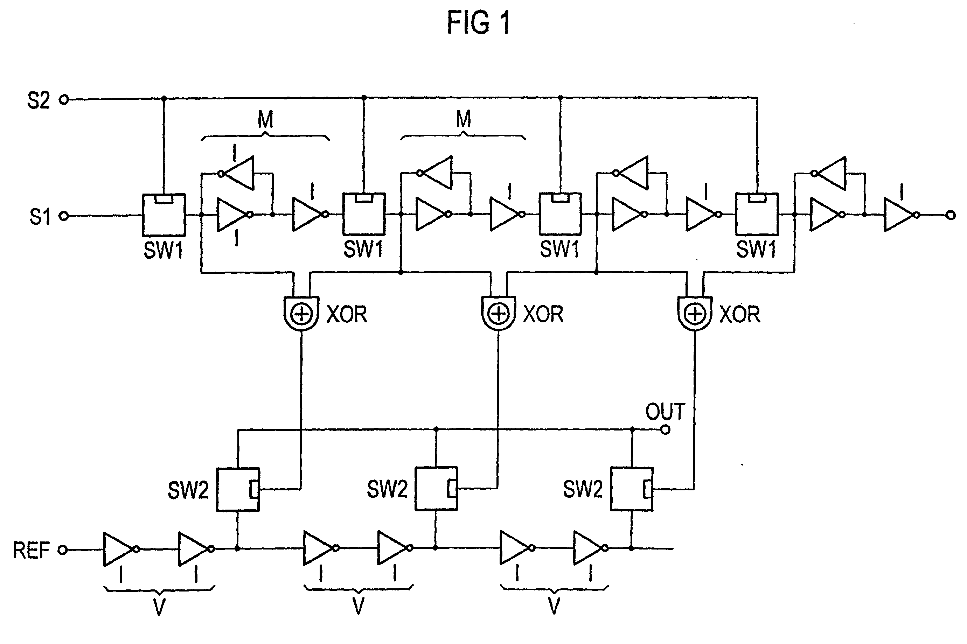

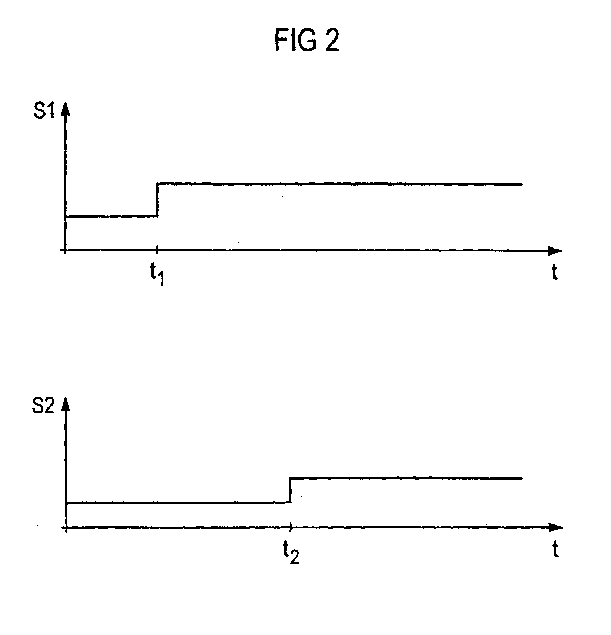

Die erfindungsgemäße Schaltung in Figur 1 weist eine Reihenschaltung von Grundelementen auf, von denen jedes eine erste Schalteinheit SW1 und eine Speichereinheit M beinhaltet. Jede Speichereinheit M weist zwei gegenparallel angeordnete Inverter I, die eine Halteschaltung bilden, und einen diesen nachgeschalteten weiteren Inverter I auf. Dem Eingang der Reihenschaltung der Grundelemente wird ein erstes Signal S1 zugeführt. Wenn alle ersten Schalteinheiten SW1 leitend geschaltet sind, läuft eine Flanke des ersten Signals S1 durch die Reihenschaltung der Grundelemente und wird dabei durch die Inverter I der Speichereinheiten M verzögert. Jede erste Schalteinheit SW1 weist einen Steuereingang auf, der mit einem zweiten Signal S2 verbunden ist. Der Schaltzustand der ersten Schalteinheiten SW1 wird durch den Signalpegel des zweiten Signals S2 bestimmt. Dies wird im folgenden anhand von Figur 2 erläutert.

Figur 2 sind die Signalverläufe der beiden Signale S1, S2 zu entnehmen. Vor einem ersten Zeitpunkt t₁ weisen beide Signale S1, S2 einen niedrigen Pegel auf. Im vorliegenden Fall bewirkt der niedrige Pegel des zweiten Signals S2, daß alle ersten Schalteinheiten SW1 leitend geschaltet sind. Daher wird der niedrige Pegel des ersten Signals S1 in allen Speichereinheiten M gespeichert. Zum ersten Zeitpunkt t₁ weist das erste Signal S1 eine positive Flanke auf, die durch die Reihenschaltung der Grundelemente übertragen wird. Dabei sind die ersten Schalteinheiten SW1 aufgrund des niedrigen Pegels des zweiten Signals S2 leitend geschaltet. Zu einem zweiten Zeitpunkt t₂ wechselt das zweite Signal S2 vom niedrigen zu einem hohen Pegel, der ein gleichzeitiges Sperren aller ersten Schalteinheiten SW1 bewirkt. Dadurch wird erreicht, daß zum zweiten Zeitpunkt t₂ die Speichereinheiten M den in ihnen gespeicherten Signalpegel jeweils beibehalten. Dies hat zur Folge, daß diejenigen Speichereinheiten M, bis zu denen sich die positive Flanke des ersten Signals S1 bis zum Zeitpunkt t₂ ausgebreitet hat, einen anderen Pegel speichern als die nachfolgenden Speichereinheiten M.

In Figur 1 sind jeweils die Eingänge zweier benachbarter Speichereinheiten M mit Eingängen eines XOR-Gatters verbunden. Am Ausgang der XOR-Gatter wird nur dann ein hoher Pegel erzeugt, wenn die beiden ihnen zugeführten Signalpegel, die in den entsprechenden Speichereinheiten M gespeichert sind, voneinander abweichen. Daher kann mittels der XOR-Gatter festgestellt werden, bis wohin sich die positive Flanke des ersten Signals S1 durch die Reihenschaltung der Grundelemente ausgebreitet hat, bevor die positive Flanke des zweiten Signals S2 aufgetreten ist. Die Ausgangssignale der XOR-Gatter zeigen also an, um wieviel die Flanke des zweiten Signals S2 gegenüber der Flanke des ersten Signals S1 verzögert ist.

Um die Ausgangssignale der XOR-Gatter weiter auszuwerten, können weitere Komponenten der erfindungsgemäßen Schaltung vorgesehen sein, wie dies in Figur 1 dargestellt ist. Die Schaltung in Figur 1 weist eine Reihenschaltung mehrerer Verzögerungselemente V auf. Jedes Verzögerungselement beinhaltet eine Reihenschaltung zweier Inverter I. Der Ausgang jedes Verzögerungselements V ist über eine zweite Schalteinheit SW2 mit einem Ausgang OUT verbunden. Die Verzögerungselemente V und die zweiten Schalteinheiten SW2 bilden eine Verzögerungseinheit, deren Eingang der Eingang der Reihenschaltung der Verzögerungselemente V ist. Dem Eingang der Verzögerungseinheit wird ein Referenzsignal REF zugeführt. Die zweiten Schalteinheiten SW2 weisen jeweils einen Steuereingang auf, der mit dem Ausgang je eines der XOR-Gatter verbunden ist. Nach dem Auftreten der positiven Flanke des zweiten Signals S2 zum zweiten Zeitpunkt t₂ weist nur ein Ausgangssignal der XOR-Gatter einen hohen Pegel auf. Die zweiten Schalteinheiten SW2 sind gesperrt, wenn ihrem Steuereingang ein niedriger Pegel zugeführt wird, und leiten, wenn ihnen ein hoher Pegel zugeführt wird. Daher leitet zum zweiten Zeitpunkt t₂ nur diejenige zweite Schalteinheit SW2, deren XOR-Gatter an seinem Ausgang einen hohen Pegel liefert. Flanken des Referenzsignals REF werden durch die Verzögerungselemente V verzögert an den Ausgang OUT der Verzögerungseinheit ausgegeben. Dabei ist der Grad der Verzögerung abhängig davon, wieviele der Verzögerungselemente V durchlaufen werden. Das wiederum wird dadurch bestimmt, welche der zweiten Schalteinheiten SW2 jeweils leitend ist. Somit ergibt sich eine Einstellung der Verzögerung des Referenzsignals REF durch die Verzögerungseinheit in Abhängigkeit vom Ausgangssignal der XOR-Gatter und damit in Abhängigkeit von der Zeitdifferenz zwischen den Flanken der beiden Signale S1, S2.

Als Referenzsignal REF eignet sich insbesondere ein Taktsignal. Die ersten und zweiten Schalteinheiten SW1, SW2 können beispielsweise mittels Transistoren realisiert sein. Es kann sich dabei insbesondere um Transfergates handeln. Als Speichereinheiten M können auch andere als die in Figur 1 gezeigten zum Einsatz kommen. In jedem Fall weist die in Figur 1 im oberen Teil gezeigte Anordnung der Reihenschaltung der Grundelemente den Vorteil auf, daß die darin enthaltenen Speichereinheiten M außer ihrer Speicherfunktion auch der Verzögerung der Flanke des ersten Signals S1 innerhalb der Reihenschaltung der Grundelemente dient. Die Speichereinheiten M üben also eine Doppelfunktion aus. Es kann somit auf zusätzliche Verzögerungselemente in der Reihenschaltung bzw. zusätzliche Speichermittel außerhalb der Reihenschaltung der Grundelemente verzichtet werden, so daß die gezeigte Schaltung mit relativ wenigen Komponenten auskommt.

Abweichend von Figur 1 können die Grundelemente neben den Speichereinheiten M und den ersten Schalteinheiten SW1 weitere Verzögerungseinheiten, beispielsweise in Form weiterer Inverter enthalten, um größere Verzögerungszeiten je Grundelement zu erreichen. Die in Figur 1 dargestellte Realisierung der Speichereinheiten M durch drei Inverter I weist den Vorteil eines besonders einfachen Aufbaus mit nur wenigen Komponenten auf. Gleichzeitig ergibt sich durch die Reihenschaltung der Inverter I innerhalb der Speichereinheiten M ebenso wie bei gewöhnlichen Verzögerungsschaltungen der Vorteil einer einfachen und genauen Einstellung der gewünschten Laufzeiten des ersten Signals S1 durch die Reihenschaltung.

## Patentansprüche

1. Schaltung zur Ermittlung der Zeitdifferenz zwischen Flanken eines ersten (S1) und eines zweiten (S2) digitalen Signals
- mit einem ersten Eingang zum Zuführen des ersten Signals (S1 zu einer Reihenschaltung mehrerer Grundelemente, wobei jedes Grundelement eine Speichereinheit (M) zum Speichern des am Eingang des Grundelementes anliegenden Signalpegels aufweist, wobei der Ausgang des Speicherelementes (M) mit dem Eingang des nächsten Grundelementes verbunden ist,
- mit einem zweiten Eingang zum Zuführen des zweiten Signals (S2), der mit einem Steuereingang jedes Grundelementes verbunden ist, wobei die Speicherelemente (M) bei einem ersten Pegel des zweiten Signals den im vorhergehenden Speicherelement gespeicherten Signalpegel übernehmen und wobei die Speicherelemente (M) bei einem zweiten Pegel des zweiten Signals, den jeweils in ihnen gespeicherten Signalpegel beibehalten,
- und mit Vergleichseinheiten (XOR), denen jeweils die von den Speichereinheiten (M) zweier benachbarter Grundelemente gespeicherten Signalpegel zugeführt werden, woraufhin die Vergleichseinheiten an ihren Ausgängen entsprechende Ergebnissignale liefern,
- wobei jede Vergleichseinheit (XOR) bei Zuführung zweier gleicher Signalpegel ein anderes Ergebnissignal liefert als bei Zuführung zweier unterschiedlicher Signalpegel.

2. Schaltung nach Anspruch 1,
deren Grundelemente jeweils eine Reihenschaltung einer ersten Schalteinheit (SW1) und des Speicherelementes (M) enthalten, wobei der Steuereingang des Grundelementes ein Steuereingang der Schalteinheit ist.

3. Schaltung nach Anspruch 1 oder 2,
deren Vergleichseinheiten (XOR) XOR-Gatter sind.

4. Schaltung nach einem der vorstehenden Ansprüche,
- mit einer Verzögerungseinheit mit einem Eingang zur Zuführung eines Referenzsignals (REF) und mit einem Ausgang (OUT),
- wobei der Eingang der Verzögerungseinheit mit einer Reihenschaltung mehrerer Verzögerungselemente (V) verbunden ist,
- wobei die Verzögerungseinheit zweite Schalteinheiten (SW2) aufweist, die jeweils zwischen einem Ausgang je eines der Verzögerungselemente und dem Ausgang (OUT) der Verzögerungseinheit angeordnet sind,
- wobei die zweiten Schaltelemente (SW2) einen Steuereingang aufweisen, der mit dem Ausgang eines der Vergleichseinheiten (XOR) verbunden ist.

5. Schaltung nach einem der vorstehenden Ansprüche,
deren Speichereinheiten jeweils zwei gegenparallel angeordnete Inverter aufweisen.

## Claims

1. Circuit for determining the time difference between edges of a first digital signal (S1) and of a second digital signal (S2)
- having a first input for supplying the first signal (S1) to a series circuit composed of a plurality of basic elements, each basic element having a storage unit (M) for storing the signal level which is applied to the input of the basic element, the output of the storage element (M) being connected to the input of the next basic element,
- having a second input for supplying the second signal (S2) which is connected to a control input of each basic element, in which case given a first level of the second signal the storage elements (M) take up the signal level stored in the preceding storage element, and in which case given a second level of the second signal the storage elements (M) retain the signal level respectively stored in them,
- and having comparator units (XOR) to which in each case the signal levels stored by the storage units (M) of two adjacent basic elements are supplied, in response to which the comparator units supply appropriate result signals at their outputs,
- each comparator unit (XOR) supplying a different event signal when two identical signal levels are supplied than when two different signal levels are supplied.

2. Circuit according to Claim 1, the basic elements of which each contain a series circuit composed of a first switching unit (SW1) and of the storage element (M), the control input of the basic element being a control input of the switching unit.

3. Circuit according to Claim 1 or 2, the comparator units (XOR) of which are XOR gates.

4. Circuit according to one of the preceding claims,
- having a delay unit with an input for supplying a reference signal (REF) and having an output (OUT),
- the input of the delay unit being connected to a series circuit composed of a plurality of delay elements (V),
- the delay unit having second switching units (SW2) which are respectively arranged between an output of, in each case, one of the delay elements and the output (OUT) of the delay unit,
- the second switching elements (SW2) having a control input which is connected to the output of one of the comparator units (XOR).

5. Circuit according to one of the preceding claims, the storage units of which each have two inverters which are connected in antiparallel.

## Revendications

1. Circuit de détermination de la différence temporelle entre des flancs d'un premier (S1) et d'un second (S2) signal numérique
- comprenant une première entrée d'envoi du premier signal (S1) à un circuit série composé de plusieurs éléments de base, chaque élément de base ayant une unité (M) de mémoire, destinée à mémoriser le niveau de signal appliqué à l'entrée de l'élément de base, la sortie de l'élément (M) de mémoire étant reliée à l'entrée de l'élément de base immédiatement suivant,
- comprenant une deuxième entrée d'envoi du deuxième signal (S2), qui est reliée à une entrée de commande de chaque élément de base, les éléments (M) de mémoire prenant en charge pour un premier niveau du second signal le niveau de signal mémorisé dans l'élément de mémoire précédent et les éléments (M) de mémoire conservant, pour un second niveau du second signal, des niveaux de signal qui sont mémorisés, respectivement,
- et comprenant des unités (XOR) de comparaison auxquelles sont envoyés respectivement les niveaux de signal mémorisés par les unités (M) de mémoire de deux éléments de base voisins, les unités de comparaison fournissant alors à leur sortie des signaux de résultat correspondant,
- chaque unité (XOR) de comparaison fournissant, lors de l'envoi de deux niveaux de signal identiques un autre signal de résultat que lors de l'envoi de deux niveaux de signal différents.

2. Circuit suivant la revendication 1,
dont les éléments de base contiennent respectivement un circuit série d'une première unité (SW1) de commutation et de l'élément (M) de mémoire, l'entrée de commande de l'élément de base étant une entrée de commande de l'unité de commutation.

3. Circuit suivant la revendication 1 ou 2,
dont les unités (XOR) de comparaison sont des portes XOR.

4. Circuit suivant l'une des revendications précédentes,
- comprenant une unité de temporisation ayant une entrée d'envoi d'un signal (REF) de référence et une sortie (OUT),
- l'entrée de l'unité de temporisation étant reliée à un circuit série constitué de plusieurs éléments (V) de temporisation,
- l'unité de temporisation ayant deux unités (SW2) de commutation, qui sont montées respectivement entre une sortie de respectivement l'un des éléments de temporisation et la sortie (OUT) de l'unité de temporisation,
- les deux éléments (SW2) de commutation ayant une entrée de commande qui est reliée à la sortie de l'une des unités (XOR) de comparaison.

5. Circuit suivant l'une des revendications précédentes,
dont les unités de mémoire ont respectivement deux inverseurs montés de manière anti-parallèle.
